(19) Europäisches Patentamt
European Patent Office
Office européen des brevets

(11) **EP 4 409 311 B1**

(12) **EUROPÄISCHE PATENTSCHRIFT**

(45) Veröffentlichungstag und Bekanntmachung des Hinweises auf die Patenterteilung:
**28.01.2026 Patentblatt 2026/05**

(21) Anmeldenummer: **22789466.4**

(22) Anmeldetag: **26.09.2022**

(51) Internationale Patentklassifikation (IPC):
**G01R 33/00** (2006.01)   **G01R 33/12** (2006.01)
**G01R 33/028** (2006.01)   **G01N 27/02** (2006.01)

(52) Gemeinsame Patentklassifikation (CPC):
**G01R 33/0035; G01R 33/028; G01R 33/12**

(86) Internationale Anmeldenummer:
**PCT/DE2022/100712**

(87) Internationale Veröffentlichungsnummer:
**WO 2023/051868 (06.04.2023 Gazette 2023/14)**

(54) **INDIREKTES KALIBRIERVERFAHREN FÜR EIN ELEKTROMAGNETISCHES INDUKTIONSVERFAHREN UND MESSANORDNUNG ZUR DURCHFÜHRUNG DES VERFAHRENS**

INDIRECT CALIBRATION METHOD FOR AN ELECTROMAGNETIC INDUCTION METHOD, AND MEASURING ASSEMBLY FOR CARRYING OUT THE METHOD

PROCÉDÉ D'ÉTALONNAGE INDIRECT POUR UN PROCÉDÉ D'INDUCTION ÉLECTROMAGNÉTIQUE ET ENSEMBLE DE MESURE POUR LA MISE EN OEUVRE DU PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.09.2021 DE 102021125036**

(43) Veröffentlichungstag der Anmeldung:
**07.08.2024 Patentblatt 2024/32**

(73) Patentinhaber: **Alfred-Wegener-Institut Helmholtz-Zentrum für Polar- und Meeresforschung 27570 Bremerhaven (DE)**

(72) Erfinder:
• **ROHDE, Jan**
  **27570 Bremerhaven (DE)**
• **HENDRICKS, Stefan**
  **28203 Bremen (DE)**
• **HAAS, Christian**
  **27574 Bremerhaven (DE)**
• **ZWANZIG, Thomas**
  **30159 Hannover (DE)**

(56) Entgegenhaltungen:
**DE-C2- 4 000 018       US-A1- 2015 268 369
US-A1- 2018 136 290**

**Beschreibung**

Die Erfindung bezieht sich auf ein indirektes Kalibrierverfahren für ein elektromagnetisches Induktionsverfahren zur Bestimmung von physikalischen Parametern eines elektrisch leitfähigen Mediums aus dem Verhältnis eines in einer Empfangsspule empfangenen magnetischen Sekundärfelds zu einem von einer mit einem Sendesignalgenerator elektrisch verbundenen Sendespule ausgesendeten magnetischen Primärfeld, wobei als Maß für das Verhältnis eine Empfangsspannung an einem Ausgang eines mit der Empfangsspule elektrisch verbundenen Empfangsverstärkers gemessen wird, die mittels einer Serienschaltung aus zumindest einer Kalibrierspule und eines veränderbaren Kalibrierwiderstands sowie eines durch diesen einstellbaren Kalibrierfaktors kalibriert wird, und auf eine Messanordnung zur Durchführung des Verfahrens mit zumindest einer Sendespule und einer Empfangsspule sowie mit einer Serienschaltung zumindest aus einer Kalibrierspule und einem Kalibrierwiderstand.

Beim elektromagnetischen Induktionsverfahren wird der Effekt genutzt, dass in einem leitfähigen Medium durch starke magnetische Wechselfelder Wirbelströme induziert werden. Diese Wirbelströme sind die Ursache von sekundären magnetischen Feldern, die nach Betrag und Phase gemessen werden können. So kann näherungsweise die mittlere Leitfähigkeit des Mediums als physikalischer Parameter gemessen werden. Die Messung kann entweder im Zeitbereich (Amplituden-Abklingzeit des Sekundärfelds) oder im Frequenzbereich (Amplituden- und Phasenverschiebung des Sekundärfelds) durchgeführt werden.

In der Messanordnung zur Durchführung des Verfahrens wird durch eine Sendespule ein starkes magnetisches Wechselfeld erzeugt. In einem Abstand im Meterbereich von der Sendespule ist eine Empfangsspule angeordnet. Diese Empfangsspule detektiert das vom Medium am Untergrund ausgesendete Sekundärfeld und wandelt es in eine Spannung um. Diese Spannung wird verstärkt und in einer Datenerfassung nach Betrag und Phase (komplexe Größe) gemessen. Am Ort der Empfangsspule ist neben dem Sekundärfeld auch ein sehr starkes Primärfeld präsent, das durch die Sendespule erzeugt wird. Die Auswertung des Sekundärfelds erfolgt als Verhältnis zwischen Sekundärfeld und Primärfeld am Ort der Empfangsspule. Da das Primärfeld um einige Größenordnungen stärker als das Sekundärfeld ist, wird das Verhältnis der Felder üblicherweise in PPM (Parts Per Million) angegeben. Da das Sekundärfeld sehr schwach ist, muss die in der Empfangsspule induzierte Spannung verstärkt werden. Damit das starke Primärfeld den erforderlichen Verstärker nicht in Sättigung treibt, wird in der Messanordnung in der Regel noch eine Kompensationsspule installiert, die ortsnah zur Sendespule angeordnet und so orientiert ist, dass sie die durch das Primärfeld induzierte Spannung in der Empfangsspule kompensiert. Um eine Aussage darüber treffen zu können, welche gemessene Spannung welchem Verhältnis von Sekundärfeld zu Primärfeld entspricht, muss eine Kalibrierung der Messanordnung durchgeführt werden. Diese erfolgt mittels einer Kalibrierspule, die ein bekanntes Verhältnis von einem Kalibrierfeld zu Primärfeld erzeugt.

Nachfolgend werden die verschiedenen Spulen in ihren Funktionen und Anordnungen in einer Messanordnung zur Durchführung des elektromagnetischen Induktionsverfahren näher erläutert:

| | |
|---|---|
| Sendespule | erzeugt das Sendefeld (magnetisches Wechselfeld) durch den Sendestrom, der von einem Generator für das Sendesignal erzeugt wird, |
| Abnehmerspule | angeordnet bei der Sendespule, um die Stärke des Sendefelds zu messen, |
| Kompensationsspule | angeordnet bei der Sendespule, kompensiert die durch das Primärfeld (magnetisches Wechselfeld) in der Empfangsspule induzierte Spannung (Erhöhung Empfindlichkeit Sekundärfeld), |
| Empfangsspule | angeordnet im Meterbereich von der Sendespule entfernt, empfängt das Sekundärfeld, |
| Kalibrierspule | erzeugt durch den Kalibrierstrom ein Kalibrierfeld als Sekundärfeld (auch Kalibriersignal oder Kalibrierpuls) mit exakt bekannter Amplitude und Phase zum Zeitpunkt der Kalibrierung. |

Grundsätzlich kann das direkte Kalibrieren der Empfangsspannung durch direktes Erzeugung eines Kalibrierpulses mit bekannter Amplitude und Phase vom indirekten Kalibrieren, bei dem eine Kalibrierspule zur Erzeugung des Kalibrierpulses genutzt wird, unterschieden werden. In der Serienschaltung von Kalibrierspule und Kalibrierwiderstand ergibt sich ein komplexer Widerstand der die Phase und Amplitude des veränderlichen Kalibrierpulses beeinflusst. Das Verhältnis von Kalibrierfeld zu Primärfeld wird "Kalibrierfaktor" genannt, der im Stand der Technik bislang rein rechnerisch aus Spulengeometrien bestimmt wird. Dabei fungiert das Kalibrierfeld bei der Kalibrierung als Sekundärfeld und der Kalibrierfaktor stellt faktisch den Sollwert dar, der bei Auftreten des Kalibrierpulses in der Kalibrierspule von der Messanordnung gemessen werden soll. Die Erfindung beschäftigt sich mit dem indirekten Kalibrierverfahren in der Anwendung beim elektromagnetischen Induktionsverfahren, speziell mit der Ermittlung des Kalibrierfaktors.

**Stand der Technik**

Prinzipiell wird das indirekte Kalibrierverfahren in der DE 40 00 018 C2 erläutert. Zur Kalibrierung des Systems wird eine weitere separate Spule im System installiert. Diese Kalibrierspule erzeugt ein nach Betrag und Phase bekanntes Verhältnis von Sekundärfeld zu Primärfeld am Ort der Empfangsspule und ermöglicht die Kompensation aller Verstärkungen und Phasendrehungen der Messanordnung (Sensorsystem und nachgeschaltete Elektronik). Üblicherweise wird die Kalibrierspule koplanar zwischen Sende- und Empfangsspule installiert. Während des Kalibriervorgangs wird sichergestellt, dass kein Sekundärfeld durch den zu untersuchenden leitenden Medium gemessen werden kann. Durch Überbrücken der Anschlüsse der Kalibrierspule mit einem bekannten komplexen, nicht veränderbaren Widerstand wird nun durch das Primärfeld ein Strom in der Spule induziert, der wiederum ein sekundäres Kalibrierfeld an der Empfangsspule zur Folge hat. Durch Berechnung des magnetischen Moments der Kalibrierspule kann damit zur Kalibrierung der Messanordnung das Verhältnis von sekundärem Kalibrierfeld zu Primärfeld berechnet werden. Zur Berechnung des magnetischen Moments müssen die Abstände zwischen Sende-, Kalibrier- und Empfangsspule sehr genau ermittelt werden. Die Abstände gehen in der dritten Potenz in die Berechnung des Moments ein, wodurch diese Messung eine große Fehlerquelle darstellt. Außerdem müssen die Spulen zueinander einen deutlichen Abstand aufweisen, damit die Näherung über das magnetische Moment angewendet werden kann. Durch den vorhandenen Abstand zwischen Kalibrierspule und Empfangsspule ist deren induktive Kopplung aber sehr schwach und nicht direkt messbar.

Aus der WO 2012 1 146930 A2 ist ein indirektes Kalibrierverfahren auf dem Gebiet der Materialprüfung bekannt, das eine oder mehrere Kalibrierspulen temporär während des Kalibrierens in die Nähe eines Magnetometers bringt, die den Effekt eines Metallgegenstands in der Nähe des Magnetometers simulieren sollen. Der Kalibrierstrom in den Kalibrierspulen wird durch das magnetische Feld des Magnetometers erzeugt, wobei die Kalibrierspulen die Empfindlichkeit diesem gegenüber erhöhen sollen. Über den Kalibriervorgang an sich und insbesondere darüber, wie der Kalibrierfaktor bestimmt wird, werden keine Aussagen gemacht. Aus der EP 2 790 030 A1 ist ein direktes Kalibrierverfahren bekannt, bei dem ein aktiver Puls bekannter Größe durch die Kalibrierspule geleitet wird. Ziel ist es, die absolute Feldstärke zu messen und die Hysterese im Sensor zu korrigieren. Aus der DE 10 2009 026 403 A1 ist ein System für eine geophysikalische Messmethode bekannt, bei dem der Pfad zwischen Sende- und Empfangsspule überwacht wird, indem die induktive Kopplung zwischen beiden gemessen wird. Zu Diagnosezwecken genügt die Messung eines ersten elektrischen Signals im Primärkreis bei geschlossenem Kurzschlusspfad, über den eine definierte induktive Kopplung zwischen Sende- und Empfangsspule erfolgt, wobei die Definierung aber unklar bleibt. Es wird die Impedanz der beiden Spulen gemessen, wobei Primär- und Sekundärspule über einen Kurzschlusspfad verbunden sind und die an diesen die Spannungen bzw. Ströme gemessen werden. Die EP 2 657 762 A2 beschäftigt sich mit der Messung von Leitfähigkeiten von Untergründen in der Geophysik. Es wird jedoch keine Kalibrierung durchgeführt, sondern die Schwankungen des Primärfeldes kompensiert. In der DE 10 2018 220 532 A1 wird ein direktes Kalibrierverfahren beschrieben, die mit einem bekannten Puls in die Empfangsspule arbeitet. Die Kalibrierung erfolgt durch Anlegen einer gepulsten Gleichspannung an die Sende- bzw. Empfangsspule durch die Kalibriereinrichtung. Eine separate Kalibrierspule ist nicht vorhanden. Auch aus der DE 20 2005 020 193 U1 ist ein direktes Kalibrierverfahren bekannt, bei dem definierte Magnetfelder erzeugt werden, um Magnetfeldsonden zu kalibrieren. Deren Einflüsse auf das erzeugte Feld sollen kompensiert werden.

Aus der US 2015 / 0 268 369 A1 ist wiederum ein direktes Kalibrierverfahren bekannt, bei dem der Kalibrierpuls eine bekannte Spannung und Form hat. Dann wird die Spannung an der Kalibrierspule, die zur Vermeidung großer Induktivitäten wenige Windungen aufweisen muss und die nur temporär nah an der Empfangsspule platziert wird, absolut gemessen und daraus der Strom durch die Kalibrierspule in der Serienschaltung mit dem Kalibrierwiderstand ermittelt. Dieser bekannte Strom dient dann der direkten Kalibrierung der Empfangsspule. Die Empfindlichkeit der Messanordnung wird über die Geometrie der Empfangsspule berechnet. Der Kalibrierfaktor muss im Vorfeld bei einer niedrigen Frequenz berechnet werden und dient als Stützstelle für eine relative Amplituden- und Phasenmessung bei höheren Frequenzen. Ziel der bekannten Messanordnung ist es, Schwankungen in der Stärke des Sendesignals zu korrigieren.

Aus der **Veröffentlichung** Wang, Haowen [et al.]: A time-domain feedback calibration method for air-coil magnetic sensor, in: Measurement, Vol. 135, 2029, S.61-70. - ISSN 0263-2241 ist es bekannt, über einen iterativen Algorithmus zu versuchen, das Kalibriersignal, das in die Kalibrierspule eingespeist wird, am Ausgang des Empfangsverstärkers so gut wie möglich zu rekonstruieren. Dabei wird die Übertragungsfunktion des Empfangssystems so lange angepasst, bis der Fehler zwischen Kalibriersignal und Empfangssignal klein genug ist. Dafür muss die Form des Kalibrierpulses so genau wie möglich bestimmt werden. Auch bei diesem direkten Kalibrierverfahren soll das Empfangssystem über ein bekanntes Kalibriersignal kalibriert werden, der Kalibrierfaktor ist also wiederum bekannt. Als Kalibriersignal wird ein abklingendes Feld genutzt, das durch die Unterbrechung einer Gleichspannung durch die Kalibrierspule erzeugt wird. Die Spannung an der Kalibrierspule wird nicht gemessen. Durch den Algorithmus wird die Bestimmung der Übertragungsfunktion unabhängig von der Gegeninduktivität zwischen Kalibrierspule und Empfangsspule. Zur Anwesenheit eines Sekundärfeldes muss die Kalibrierung in Bodennähe erfolgen, wobei während des gesamten Kalibriervorgangs die Sendespule ausgeschaltet ist.

Aus der **Veröffentlichung** Haas, Christian [et al.]: Airborne electromagnetic measurements of sea ice thickness: methods and application. Luxembourg: Arctic sea ice thickness: past, present and future. Office for Official Publications of the European Communities, 2006, S. 136-148 - ISBN 92-79-02803-0 ist es bekannt, ein indirektes Kalibrierverfahren für ein elektromagnetisches Induktionsverfahren zur Bestimmung von physikalischen Parametern eines elektrisch leitfähigen Mediums einzusetzen. Bei dem zu bestimmenden physikalischen Parameter handelt es sich dabei um die Leitfähigkeit des leitfähigen Mediums, in diesem Fall dann das Meerwasser, aus der dann die Dicke von darauf schwimmendem Meereis abgeleitet werden kann.

Die bekannten Kalibrierverfahren können also alle entweder der direkten oder der indirekten Kalibrierung zugeordnet werden, wobei alle bekannten Verfahren grundsätzlich einstufig ausgebildet sind. Bei der direkten Kalibrierung wird eine direkte Einspeisung einer bekannten Spannung oder eines bekannten Stroms in die Kalibrierspule genutzt. Bei der indirekten Kalibrierung mit Nutzung einer Kalibrierspule wird der Kalibrierfaktor entweder über die Spulengeometrien und die Messung des Widerstands der Kalibrierspule berechnet oder er wird als bekannt vorausgesetzt. Das der Erfindung nächstliegende indirekte Kalibrierverfahren ist aus der WO 2012/146930 A1 vor dem Hintergrund der DE 40 00 018 C2 bekannt.

## Aufgabenstellung

Davon ausgehend ist die **Aufgabe** für die vorliegende Erfindung darin zu sehen, ein Kalibrierverfahren für ein elektromagnetisches Induktionsverfahren anzugeben, bei dem der Kalibrierfaktor nicht aufwändig und deutlich fehlerbehaftet berechnet werden muss. Darüber hinaus soll die Erfindung eine besonders kompakte Messanordnung ermöglichen. Die erfindungsgemäße **Lösung** dieser Aufgabe ist dem Haupanspruch zu entnehmen. Vorteilhafte Weiterbildungen des erfindungsgemäßen Verfahrens sind den Unteransprüchen zu entnehmen ebenso wie eine bevorzugte Anwendung des Verfahrens. Ebenfalls zur Lösung trägt eine bevorzugte Messanordnung gemäß dem Erzeugnisanspruch mit in den zugeordneten Unteransprüchen aufgezeigten vorteilhaften Modifikationen bei.

Bei dem erfindungsgemäßen Kalibrierverfahren, welches ein indirektes Kalibrierverfahren unter Anwesenheit einer Kalibrierspule darstellt, wird in der ersten Stufe der Kalibrierfaktor zunächst rein messtechnisch durch die Messung einer aufgrund eines elektrisch erzeugten Kalibrierpulses bewirkten Gegeninduktivität zwischen der Empfangsspule und der damit induktiv gekoppelten Kalibrierspule bestimmt. Dabei ist die induktive Kopplung zwischen Kalibrierspule und Empfangsspule so stark, dass sie messbar ist. Eine reine Berechnung über die Spulengeometrien und eine Messung des Widerstands der Kalibrierspule wird bei der Erfindung nicht durchgeführt, wodurch der auftretende Fehler bei der Bestimmung des Kalibrierfaktors deutlich reduziert werden kann. In der zweiten Stufe des erfindungsgemäßen Verfahrens wird mit dem in der ersten Stufe messtechnisch bestimmten Kalibrierfaktor dann die eigentliche Kalibrierung der Messanordnung durchgeführt, wobei dabei dann der Kalibrierpuls durch das Primärfeld induktiv erzeugt wird. Während in der ersten Stufe des Verfahrens die Empfangsspannung an den Anschlüssen der Empfangsspule (als am Eingang des Empfangsverstärkers) gemessen wird, wird in der zweiten Stufe die Empfangsspannung hinter dem Empfangsverstärker (also am Ausgang des Empfangsverstärkers) gemessen. Diese "unbekannte" Empfangsspannung wird dann unter Anwendung des bekannten Kalibrierfaktors auf das zu messende Verhältnis von Sekundär- zu Primärfeld bezogen. Dabei wird der in der ersten Stufe eingestellte Wert des Kalibrierwiderstands, der in der zweiten Stufe über die Kalibrierspule kurzgeschlossen ist, nicht verändert. Der Kalibrierfaktor gibt somit an, welches Verhältnis von Sekundärfeld zu Primärfeld im Augenblick der Kalibrierung an der Empfangsspule anliegt, wodurch der gemessene Spannungswert darauf bezogen werden kann.

Der Unterschied des erfindungsgemäßen Verfahrens zu den bekannten indirekten Kalibrierverfahren besteht in der Art und Weise, wie der Kalibrierpuls in der Kalibrierspule erzeugt wird und in der rein messtechnischen Bestimmung der Größe des Kalibrierfeldes bzw. des Kalibrierfaktors. Die Kombination aus der Anordnung von Kalibrier- und Empfangsspule in geringstmöglichen Abstand und die dadurch ermöglichte direkte Messung der induktiven Kopplung mit einfachen Mitteln sowie der anschließenden Kalibrierung über das anwesende Primärfeld ist charakteristisch für die Erfindung.

Außerdem entfällt bei der Erfindung die starke Fehlerquelle des in die reine Berechnung des Kalibrierfaktors eingehenden Spulenabstands, die Kalibrierung wird dadurch deutlich genauer. In der ersten Stufe ist die Sendespule inaktiv (es fließt kein Strom durch die Sendespule) oder abgeschirmt, sodass auch kein Sendesignal von der Sendespule an der Empfangsspule ankommen kann. Stattdessen wird ein Kalibriersignalgenerator mit der Kalibrierspule elektrisch verbunden, der einen veränderlichen Kalibrierstrom ausgibt. Hierbei kann es sich um ein sinusförmiges Signal handeln, andere pulsierende Wechselsignale zur Erzeugung von induzierten Strömen sind auch geeignet. Die Kalibrierspule ist mit dem Kalibriersignalgenerator und dem Kalibrierwiderstand, der veränderlich und rein ohmscher oder auch schon komplexer Natur sein kann, in einer Serienschaltung elektrisch verbunden, es ergibt sich durch die Kalibrierspule ein komplexer Kalibrierwiderstand. Der pulsierende Kalibrierstrom erzeugt in der Kalibrierspule einen Kalibrierpuls (induzierter Strom in der Spule mit der Folge eines sekundären magnetischen Feldes), der wiederum durch die induktive Kopplung einen magnetischen Fluss in der Empfangsspule (daher sind die Begriffe "induktive Kopplung" und "magnetische Kopplung" äquivalent) erzeugt, der wiederum eine Empfangsspannung an den Anschlüssen der Empfangsspule (am Eingang des Empfangsverstärkers) erzeugt. Dann werden gleichzeitig die Empfangs- und die Kalibrierspannung an den Anschlüssen des Signalgenerators gemessen, also über die Serienschaltung von Kalibrierspule und Kalibrierwiderstand, dem komplexen Kalibrierwiderstand, und vor dem Empfangsverstärker. Über diese Spannungen wird die Gegeninduktivität zwischen Empfangs- und Kalibrierspule berechnet, aus der wiederum der Kalibrierfaktor als Verhältnis eines durch das Primärfeld in der Kalibrierspule induzierten Sekundärfeldes sowie des Primärfeldes am Ort der Empfangsspule ermittelt wird. Da ein Spannungsverhältnis für die Bestimmung des Kalibrierfaktors genutzt wird, sind die Amplitude und die Phase des in die Kalibrierspule eingespeisten Kalibriersignals bei der Erfindung nicht von Bedeutung.

Das von der Umgebung erzeugte Sekundärfeld ist gegenüber dem Kalibrierfeld der Kalibrierspule sehr klein und kann als vernachlässigbar in seinem Einfluss auf die Empfangsspule angesehen werden. Deshalb kann es bei der Kalibrierung vorhanden sein, ohne einen bedeutsamen Fehler zu erzeugen. Um aber auch diesen geringen Fehler zu vermeiden, ist es gemäß einer ersten Modifikation der Erfindung vorteilhaft und bevorzugt, wenn zumindest in der zweiten Stufe das Sekundärfeld abgeschirmt ist. Dies kann beispielsweise durch eine Magnetfelder abschirmende metallische Unterlage oder durch eine sehr große örtliche Beabstandung erfolgen. Auch zur Messung des Kalibrierfaktors in der ersten Stufe kann die gesamte Messanordnung in eine Umgebung gebracht, in der kein Sekundärfeld von einem leitfähigen Medium in der Umgebung gemessen werden kann. Alternativ kann auch in der ersten Stufe das leitfähige Medium abgeschirmt werden.

Gemäß einer weiteren Modifikation des erfindungsgemäßen Kalibrierverfahrens kann bevorzugt und vorteilhaft die erste Stufe zeitlich unabhängig von der zweiten Stufe durchgeführt werden. Bei einer von der Kalibrierung der Messanordnung in der zweiten Stufe unabhängigen Bestimmung des Kalibrierfaktors auf rein messtechnischer Basis in der ersten Stufe kann dieser beispielsweise nur einmal in einem Labor gemessen und dann im Messbetrieb in der zweiten Stufe angewendet werden. Der Kalibrierfaktor kann aber auch im Feld aktuell (und damit ein- oder mehrmals bzw. auch beliebig oft) vor der eigentlichen Kalibrierung in der zweiten Stufe gemessen werden. Durch diese zeitlich eng zugeordnete Bestimmung des Kalibrierfaktors gemäße der ersten Stufe zur Kalibrierung gemäß der zweiten Stufe wird bei der Erfindung eine präzisere Kalibrierung erreicht, die auch zeitabhängige Effekte wie Umgebungstemperatur und Materialalterung der Spulen flexibel berücksichtigt. Weitere Ausführungen zu der Ermittlung des Kalibrierfaktors auf messtechnischer Basis unter Berücksichtigung vereinfachender Randbedingungen sind den Ausführungsbeispielen zu entnehmen.

Desweiteren wird mit der Erfindung eine Messanordnung zur Durchführung des zuvor erläuterten zweistufigen Kalibrierverfahrens mit zumindest einer Sendespule und einer Empfangsspule sowie mit einer Serienschaltung einer Kalibrierspule und eines veränderbaren Kalibrierwiderstands beansprucht. Erfindungsgemäß ist bei dieser Messanordnung vorgesehen, dass die Empfangsspule und die Kalibrierspule unter Erzeugung einer dauerhaften induktiven Kopplung benachbart zueinander angeordnet sind und dass ein Kalibriersignalgenerator vorgesehen ist, der mit der Serienschaltung elektrisch verbindbar ist. Durch das Entfallen eines räumlichen Abstands zwischen der Empfangsspule und der Kalibrierspule kann die Messanordnung deutlich kompakter als bislang ausgestaltet werden. Es ergibt sich eine Platzeinsparung bei der Länge der Messanordnung von bis zu 35% der Gesamtlänge. Die Ausgestaltung von Kalibrier- und Empfangsspule kann gemeinsam und damit besonders effizient und kostensparend erfolgen.

Desweiteren wird in einer Modifikation der Messanordnung bevorzugt und vorteilhaft aufgezeigt, dass ein erster Schalter vorgesehen ist, über den die Kalibrierspule über den Kalibrierwiderstand mit dem Kalibriersignalgenerator elektrisch verbindbar ist. Nach Schließen dieses Schalters und Einschalten des Kalibriersignalgenerators wird der Kalibrierfaktor messtechnisch in der ersten Stufe bestimmt. In einer weiteren Modifikation ist bevorzugt und vorteilhaft vorgesehen, dass ein weiterer Schalter vorgesehen ist, über den die die Kalibrierspule nur mit dem Kalibrierwiderstand elektrisch verbindbar ist. Der Kalibriersignalgenerator für das Kalibriersignal fällt im geschlossenen Zustand des weiteren Schalters aus der Serienschaltung heraus. Nach Schließen des weiteren Schalters und Einschalten des Signalgenerators für das Sendesignal kann die Kalibrierung gemäß der zweiten Stufe des Kalibrierverfahrens unter Benutzung des zuvor messtechnisch bestimmten Kalibrierfaktors durchgeführt werden. Im Zusammenhang mit dem erfindungsgemäßen Verfahren wurde bereits ausgeführt, dass der Kalibrierfaktor in der ersten Stufe zeitlich und räumlich unabhängig (Labormessung) von der Kalibrierung in der zweiten Stufe oder in Verbindung mit damit (Feldmessung) messtechnisch bestimmt werden kann. Bei einer Labormessung weist eine einfache Messanordnung nur den ersten Schalter auf. Die eigentliche Messanordnung im Feld weist dann nur den weiteren Schalter auf. Bei einer Verbindung der beiden Stufen der Kalibrierung weist die Messanordnung dann entsprechend beide Schalter auf. Dadurch wird die Kalibrierung flexibel, und es können Umgebungseinflüsse und Alterung der einzelnen Komponenten berücksichtigt werden.

In einer nächsten Modifikation der mit der Erfindung beanspruchten Messanordnung ist bevorzugt und vorteilhaft vorgesehen, dass die Empfangsspule und die Kalibrierspule auf einem gemeinsamen Kern angeordnet sind und ein Flächenverhältnis von 1 aufweisen. Durch diese Ausbildung wird die messtechnische Bestimmung des Kalibrierfaktors in der ersten Stufe erleichtert und die Messanordnung weiter vereinfacht. Die Empfangsspule und die Kalibrierspule können beispielsweise Windungsverhältnisse von 200 zu 1 oder 200 zu 2 aufweisen. Beide Spulen können auch bevorzugt und vorteilhaft ein Windungsverhältnis von 1 aufweisen, sie haben dann eine gleiche Anzahl von Windungen. Auch durch diese Randbedingung wird die messtechnische Bestimmung des Kalibrierfaktors in der ersten Stufe vereinfacht. Üblich ist aber, dass die Empfangsspule eine höhere Windungszahl aufweist als die Kalibrierspule, sodass das Wicklungsverhältnis ungleich eins ist und in die Bestimmung des Kalibrierfaktors eingeht. Weitere Erläuterungen zu der vorliegenden Erfindung in ihrer Ausprägung als Verfahren und als Anordnung und ihre jeweils angesprochenen Modifikationen können dem aufgezeigten Ausführungsbeispiel entnommen werden.

Zuvor wird noch eine besonders bevorzugte Anwendung des mit der Erfindung beanspruchten Verfahrens bzw. der Messanordnung aufgezeigt, bei der als physikalischer Parameter die Dicke von Meereis bestimmt wird. Dies kann im Rahmen einer luftgestützten Anwendung des magnetischen Induktionsverfahrens erfolgen, wie sie für verschiedene Anwendungen in der Geophysik genutzt wird, beispielsweise zur geologischen Kartierung oder zur Grundwassersuche. Es werden jeweils Magnetometer eingesetzt, deren Betriebsweise und Ausgestaltung durch die vorliegende Erfindung bedeutsam verbessert werden können. Bei der Anwendung zur Ermittlung der Dicke von Meereis wird von einer Schleppsonde ein starkes magnetisches Wechselfeld ausgesendet. **In** einem leitfähigen Medium, beispielsweise salzhaltiges Meerwasser, werden dadurch Wirbelströme induziert, die wiederum Sekundärfelder zur Folge haben. Diese Sekundärfelder werden in der Schleppsonde empfangen und nach Betrag und Phase ausgewertet einschließlich Kalibrierung. Aus den Amplituden- und Phaseninformationen kann entweder die scheinbare Leitfähigkeit des Mediums oder auch der Abstand zu der Oberfläche zu einem leitfähigen Medium berechnet werden, was dem Abstand zur Eisunterseite entspricht. Über eine weitere Abstandsmessung, beispielsweise mit einem Laserabstandsmesser, kann die Entfernung zur Eisoberseite gemessen werden. Die Differenz dieser beiden Entfernungen ist die Eisdicke. Bei dem leitfähigen Medium kann es sich dabei auch um einen leitfähigen Untergrund in natürlicher Umgebung handeln.

**Ausführungsbeispiele**

Nachfolgend werden das mit der vorliegenden Erfindung beanspruchte indirekte Kalibrierverfahren sowie eine dieses umsetzende Messanordnung anhand der schematischen Figuren zum besseren Verständnis der Erfindung noch weitergehend erläutert. Dabei zeigt die

**Fig. 1**    eine vereinfachte Messanordnung bei der messtechnischen Bestimmung des Kalibrierfaktors (erste Stufe **S1)**,
**Fig. 2**    die vereinfachte Messanordnung gemäß **Fig. 1** bei der Durchführung der Kalibrierung (zweite Stufe **S2)**,
**Fig. 3**    die vereinfachte Messanordnung gemäß **Fig. 1, 2** im Detail (Stufen **S1+S2)**
**Fig. 4**    die vereinfachte Messanordnung gemäß **Fig. 1, 2, 3** im Messbetrieb und
**Fig. 5**    eine vollständige Messanordnung nach den **Fig. 1, 2, 3, 4** im Messbetrieb.

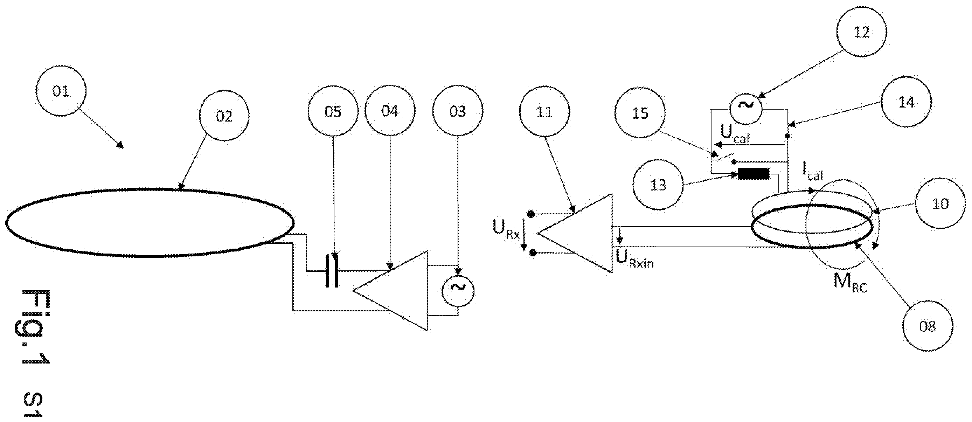

In der **Fig. 1** ist eine vereinfachte Messanordnung **01** aufgezeigt, in der links eine Sendespule **02** dargestellt ist, die mit einem Sendesignalgenerator **03** zur Erzeugung eines veränderlichen (im Ausführungsbeispiel im Frequenzbereich, im Zeitbereich würde es sich um ein pulsierendes Signal handeln) Sendesignals (im Ausführungsbeispiel sinusförmig), einem Sendeverstärker **04** und einem Resonanzkondensator **05** verbunden ist. Da in der **Fig. 1** die messtechnische Ermittlung des Kalibrierfaktors $H_{Cx}/H_P$ in der ersten Stufe **S1** erläutert werden soll, ist der Sendesignalgenerator **03** ausgeschaltet, die Sendespule **02** sendet somit kein Sendefeld $H_{Tx}$ aus, das über einen Primärpfad **06** zu einer Empfangsspule **08** gelangen könnte. Ebenfalls befindet sich im gezeigten Ausführungsbeispiel kein leitfähiges Medium **09** in beeinflussender Nähe, durch den ein Sekundärfeld $H_S$ über einen Sekundärpfad **07** in der Empfangsspule **08** erzeugt werden könnte. Erwähnte, aber nicht gezeigte Bezugszeichen sind jeweils den anderen Figuren zu entnehmen.

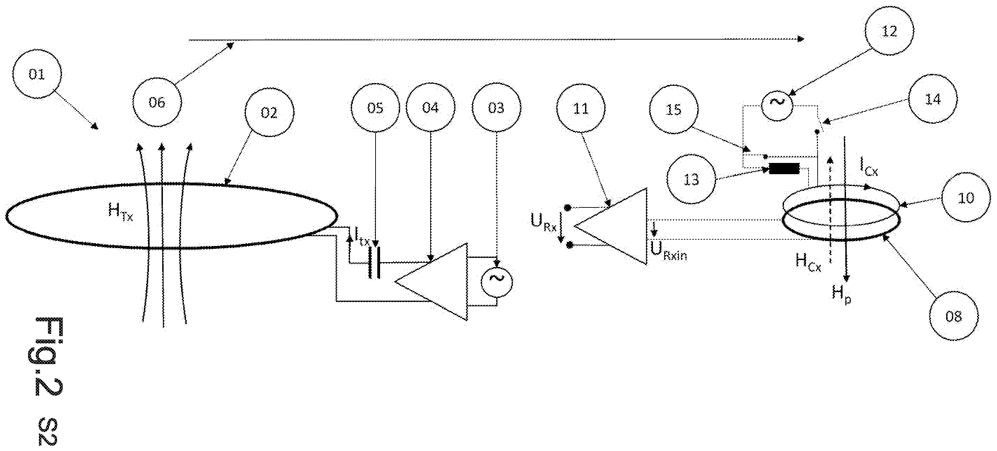

In der **Fig. 1** rechts ist die Empfangsspule **08** dargestellt, zu der in geringstmöglichem Abstand eine Kalibrierspule **10** angeordnet ist, sodass die beiden Spulen **08,10** induktiv besonders stark miteinander verkoppelt sind, was durch Vorsehen von Eisenkernen noch verstärkt werden kann. Die Empfangsspule **08** ist an einen Empfangsverstärker **11** angeschlossen, an dessen Eingang eine in der Empfangsspule **08** induzierte Spannung $U_{Rxin}$ anliegt. Am Ausgang des Empfangsverstärkers **11** wird eine Spannung $U_{Rx}$ erzeugt. Die Kalibrierspule **10** ist an einen Kalibriersignalgenerator **12** zur Erzeugung eines Kalibrierpulses in der Kalibrierspule **10** und an einen einstellbaren Kalibrierwiderstand **13**, über den die Amplitude und die Phase des durch den Kalibrierpuls von der Kalibrierspule **10** erzeugten Kalibrierfeldes $H_{Cx}$ (elektrische Erzeugung in der ersten Stufe **S1** durch den aktiven Kalibriersignalgenerator **12**) eingestellt werden können, angeschlossen. Die Reihenschaltung ist öffen- und schließbar über einen ersten Schalter **14,** der der Bestimmung des Kalibrierfaktors $H_{Cx}/H_P$ dient (erste Stufe **S1**). Durch die Reihenschaltung fließt im geschlossenen Zustand des ersten Schalters **14** und bei angeschaltetem Kalibriersignalgenerator **12** ein Strom $I_{cal}$, eine Spannung $U_{cal}$ liegt an der Serienschaltung von Kalibrierspule **10** und Kalibrierwiderstand **13** (diese beiden erzeugen gemeinsam einen komplexen Kalibrierwiderstand) an, die zur Bestimmung der starken induktiven Kopplung zwischen Kalibrierspule **10** und Empfangsspule **08** genutzt wird. Das Maß dafür ist die Gegeninduktivität $M_{RC}$. In der **Fig. 1** ist noch ein weiterer Schalter **15** gezeigt, der bei der eigentlichen Kalibrierung in Stufe **S2** genutzt wird, vergleiche **Fig. 2.**

Zur Bestimmung des Kalibrierfaktors $H_{Cx}/H_P$ ist der Sendesignalgenerator **03** zur Erzeugung des Sendesignals ausgeschaltet, das leitfähige Medium **09** im gewählten Ausführungsbeispiel abwesend oder abgeschirmt. Die Empfangsspule **08** und die Kalibrierspule **10** sind induktiv stark miteinander verkoppelt. Der erste Schalter **14** ist geschlossen, der weitere Schalter **15** ist geöffnet. Der Kalibriersignalgenerator **12** ist angeschaltet und erzeugt einen pulsartigen Strom $I_{Cal}$ in der Kalibrierspule **10,** der wiederum einen magnetischen Fluss durch die Empfangsspule **08** erzeugt, der wiederum eine Spannung $U_{Rxin}$ an den Anschlüssen der Empfangsspule **08** induziert. Über die Spannungen $U_{Cal}$ (Spannung an der Serienschaltung aus Kalibrierspule **10** und dem Kalibrierwiderstand **13,** dient als Referenz) und $U_{R-Xin}$ wird die Gegeninduktivität $M_{RC}$ zwischen der Empfangsspule **08** und der Kalibrierspule **10** bestimmt. Dazu werden die Spannungen $U_{cal}$

und $\underline{U}_{RXin}$ gemessen, wobei die Spannung $\underline{U}_{RXin}$ nach Betrag und Phase in bezug auf $\underline{U}_{cal}$ gemessen wird.

Für ein im Ausführungsbeispiel im Zeitbereich sinusförmig ausgebildetes Sendesignal (mit genau einer Frequenz im Frequenzbereich) und entsprechend für ein sinusförmiges Kalibriersignal gleicher Frequenz sowie für den eingeschwungenen Zustand kann gezeigt werden, dass die Gegeninduktivität $\mathbf{M_{RC}}$ wie folgt berechnet werden kann:

$$\underline{M}_{RC} = \frac{\underline{U}_{Rxin} \cdot \underline{Z}_{Cx}}{j\omega \cdot \underline{U}_{cal}}$$

Dabei sind alle unterstrichenen Größen komplex. $\underline{U}_{RXin}$ und $\underline{U}_{cal}$ sind die Spannungen an der Empfangsspule **08** und über die Serienschaltung aus Kalibrierwiderstand **13** und Kalibrierspule **10**. $\mathbf{Z_{Cx}}$ ist der komplexe Widerstand (Impedanz) der Serienschaltung aus Kalibrierspule **10** und Kalibrierwiderstand **13**, $\omega$ ist die Kreisfrequenz und j die imaginäre Einheit. Weiterhin kann gezeigt werden, dass der Kalibrierfaktor als Verhältnis von $\mathbf{H_{Cx}}$ und $\mathbf{H_P}$ wie folgt berechnet werden kann:

$$\frac{\underline{H}_{Cx}}{\underline{H}_P} = j\omega \cdot \frac{\underline{M}_{RC} \cdot A_{Cx} \cdot N_{Cx}}{A_{Rx} \cdot N_{Rx} \cdot \underline{Z}_{Cx}}$$

Durch Einsetzen der Gegeninduktivität $\mathbf{M_{RC}}$ entfällt die Impedanz $\mathbf{Z_{Cx}}$ und der Kalibrierfaktor $\mathbf{H_{Cx}/H_P}$ vereinfacht sich zu

$$\frac{\underline{H}_{Cx}}{\underline{H}_P} = \frac{\underline{U}_{Rxin}}{\underline{U}_{cal}} \cdot \frac{A_{Cx} \cdot N_{Cx}}{A_{Rx} \cdot N_{Rx}}$$

Dabei sind $\mathbf{A_{Cx}}$ und $\mathbf{A_{Rx}}$ die effektiven Flächen und $\mathbf{N_{Cx}}$ und $\mathbf{N_{Rx}}$ die Windungszahlen der Kalibrierspule **10** bzw. der Empfangsspule **08**. $\underline{H}_{Cx}$ ist das in der Kalibrierspule **10** erzeugte Sekundärfeld (elektrische Erzeugung in der ersten Stufe **S1** durch den aktiven Kalibriersignalgenerator **12**, induktive Erzeugung in der zweiten Stufe **S2** durch den aktiven Sendesignalgenerator **03**) und $\underline{H}_P$ das jeweils auftretende Primärfeld am Ort der Empfangsspule **08** (mit und ohne aktive Sendespule **02**). Die unterstrichenen Feldgrößen $\underline{H}_{Cx}$ und $\underline{H}_P$ zeigen wieder an, dass diese als komplexe Größen behandelt werden und entsprechend einen Betrag und eine Phase haben. Es hat sich als besonders vorteilhaft erwiesen, dass die Wicklungen der Empfangsspule **08** und der Kalibrierspule **10** auf den gleichen Rahmen gewickelt werden. Bei ausreichend dünnen Drähten können somit die Flächen $\mathbf{A_{Cx}}$ und $\mathbf{A_{Rx}}$ als identisch angenommen werden und ihr Verhältnis wird zu eins. Gleiches gilt für identische Windungszahlen für beide Spulen **08, 10,** deren Verhältnis dann ebenfalls zu eins wird, wobei weiter oben bereits ausgeführt wurde, dass in der Regel die Windungszahl der Empfangsspule **08** um Größenordnungen größer ist als die Windungszahl der Kalibrierspule **10**. Der Kalibrierfaktor $\mathbf{H_{Cx}/H_P}$ kann also durch einfache Messung der auf die Spannung $\mathbf{U_{cal}}$ normierten Spannung $\mathbf{U_{Rxin}}$ am Eingang des Empfangsverstärkers **11** gemessen und auf die eigentliche Kalibrierung in der zweiten Stufe **S2** angewendet werden.

In der **Fig. 2** ist eine vereinfachte Messanordnung **01** aufgezeigt, wobei der Aufbau der vereinfachten Messanordnung **01** gemäß **Fig. 1** entspricht, die der messtechnischen Bestimmung des Kalibrierfaktors $\mathbf{H_{Cx}/H_P}$ dient (erste Stufe **S1**). Die vereinfachte Messanordnung **01** gemäß **Fig. 02** hingegen dient der eigentlichen Kalibrierung (zweite Stufe **S2**). Es ist anzumerken, dass im gezeigten Ausführungsbeispiel die Messanordnung **01** sowohl den ersten Schalter **14** als auch den weiteren Schalter **15** in einer Kombination aufweist. Eine derartige Kombination ermöglicht eine zeitnahe Ermittlung des Kalibrierfaktors $\mathbf{H_{Cx}/H_P}$ auch im Messbetrieb im Feld und eine kompakte Messanordnung **01.** Die beiden Kalibrierstufen **S1** und **S2** können aber auch zeitlich und räumlich völlig getrennt voneinander durchgeführt werden. Es wird dann im Feld beim Messbetrieb bei der Kalibrierung in der zweiten Stufe **S2** der Kalibrierfaktor $\mathbf{H_{Cx}/H_P}$ genutzt, der einmalig in der ersten Stufe **S1** beispielsweise in einem Labor messtechnisch ermittelt wurde. Zeitabhängige Veränderungen der Messanordnung **01** und Umwelteinflüsse können dann jedoch nicht berücksichtigt werden.

Zur Durchführung der eigentlichen Kalibrierung (zweite Stufe **S2**) wird die Messanordnung **01** in gezeigten Ausführungsbeispiel eine Umgebung gebracht, in der kein Sekundärfeld $\mathbf{H_S}$ von einem leitfähigen Medium **09** gemessen werden kann, beispielsweise mit dem Flugzeug in einen große Höhe über dem Untergrund. Dann wird der weitere Schalter **15** geschlossen (bei einer kombinierten Anordnung entsprechend der erste Schalter **14** geöffnet). Die Anschlüsse der Kalibrierspule **10** werden über den zwar veränderlichen, aber in der zweiten Stufe **S2** konstant auf den Wert aus der ersten Stufe **S1** eingestellten Kalibrierwiderstand **13** verbunden und damit kurzgeschlossen. Der Sendesignalgenerator **03** ist angeschaltet und beaufschlagt die Sendespule **02** mit einem zeitlich veränderlichen Strom $\mathbf{I_{Tx}}$. Diese erzeugt ent-sprechend das Sendefeld $\mathbf{H_{Tx}}$, das über den Primärpfad **06** zur Kalibrierspule **10** gelangt, dort das Primärfeld $\mathbf{H_P}$ (nunmehr unter Einfluss des Sendefeld $\mathbf{H_{Tx}}$) erzeugt und den Kalibrierstrom $\mathbf{I_{Cx}}$ induziert, der durch den Kalibrierwiderstand **13** in seiner Phase und Amplitude beeinflusst werden kann. Der Strom $I_{Cx}$ wiederum erzeugt einen magnetischen Fluss durch die Fläche der Empfangsspule **08,** der gleichbedeutend ist mit dem magnetischen Kalibrierfeld $H_{Cx}$ am Ort der Empfangsspule **08,** die mit der Kalibrierspule **10** induktiv stark verkoppelt ist. Das erzeugte Kalibrierfeld $H_{Cx}$ stellt zum Zeitpunkt der Kalibrierung in der zweiten Stufe **S2** daher ein bekanntes Sekundärfeldfeld $H_S$ dar (im Verhältnis zum unbekannten, auftretenden Primärfeld $H_P$). Die Spannung $U_{Rx}$ am Ausgang des Empfangsverstärkers **11** wird gemessen, bevor und während das Kalibrierfeld $H_{Cx}$ vorhanden ist. Durch den aus der ersten Stufe **S1** bekannten Kaibrierfaktor ($H_{Cx}/H_P$) wird die Messanordnung **01** dann kalibriert.

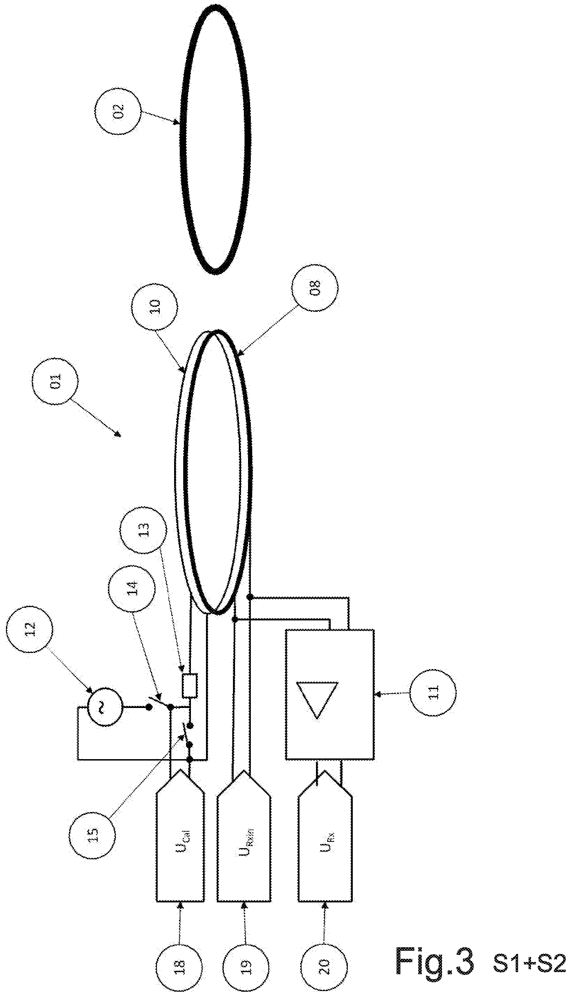

Die **Fig. 3** zeigt die Messanordnung **01** mit einer Kombination von der ersten Stufe **S1** und der zweiten Stufe **S2** gemäß **Fig. 1, 2** im Detail für einen konkreten Messaufbau (die Sendespule **02** ist rechts, die Empfangsspule **08** ist links dargestellt). Mit dem Messgerät **18** wird die Spannung $U_{cal}$ (am Ausgang des Kalibriersignalgenerators **12** zur Messung der Gegeninduktivität $M_{RC}$), mit dem Messgerät **19** die Spannung $U_{Rxin}$ (durch starke induktive Kopplung der Kalibrierspule **10** mit der Empfangsspule **08**) und mit dem Messgerät **20** die Spannung $U_{Rx}$ als eigentliches Messsignal gemessen. Nicht erwähnte Bezugszeichen sind den anderen Figuren zu entnehmen.

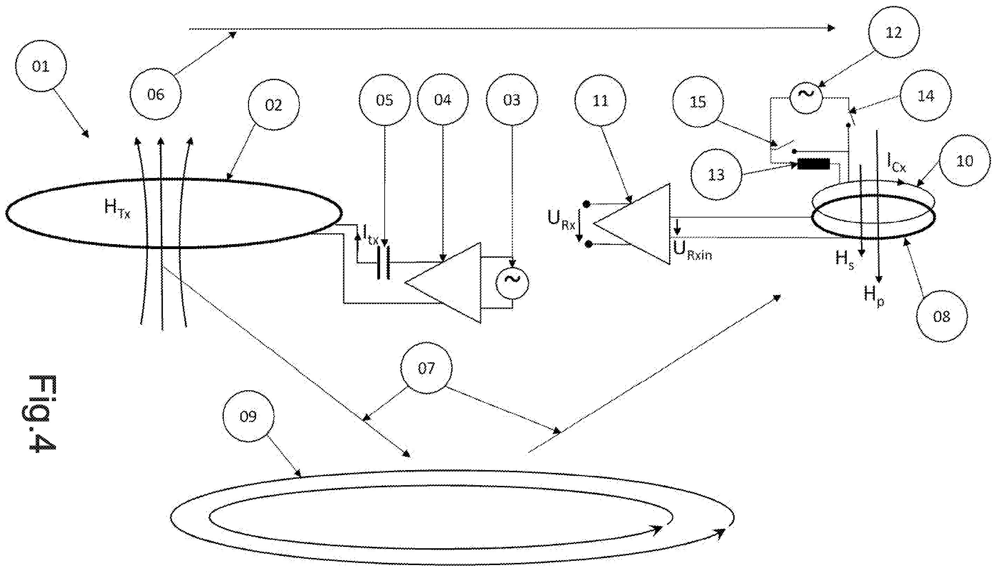

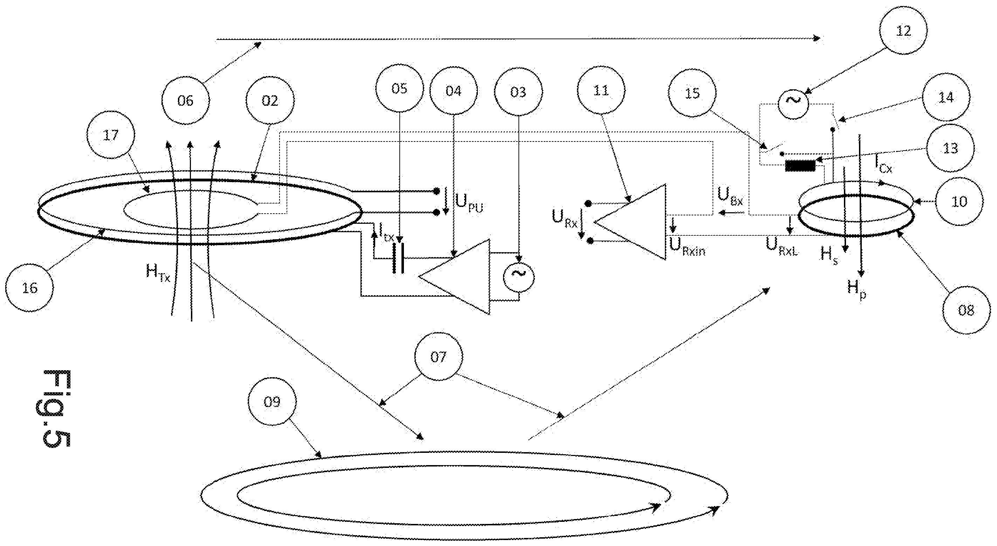

In der **Fig. 4** ist der Messbetrieb in einer vereinfachten Messanordnung **01** dargestellt. Der Sendestrom $I_{Tx}$ durch die Sendespule **02** erzeugt das Sendefeld $H_{Tx}$. Dieses breitet sich in verschiedenen Richtungen aus, wobei grundsätzlich zwischen dem Primärpfad **06** und dem Sekundärpfad **07** unterschieden wird. Entlang des Primärpfads **06** erfolgt die direkte Signalausbreitung von der Sendespule **02** zur Empfangsspule **08**. Das Sendefeld $H_{Tx}$ erzeugt am Ort der Empfangsspule **08** das Primärfeld $H_P$. Entlang des Sekundärpfads **07** erfolgt die Ausbreitung von durch das leitfähige Medium **09** erzeugten Signalen. Das Sendefeld $H_{Tx}$ induziert im leitfähigen Medium **09** (beispielsweise ein geologischer, leitfähiger Untergrund) Wirbelströme (Darstellung in **Fig. 4, 5** durch Kreise), die wiederum die Quelle von weiteren magnetischen Wechselfeldern gleicher Frequenz sind. Diese Wirbelströme erzeugen am Ort der Empfangsspule **08** das Sekundärfeld $H_S$. Aus dem Verhältnis $H_S / H_P$ kann die Leitfähigkeit des Mediums **09** berechnet werden. Für die Anwendung zur Messung der Eisdicke kann alternativ aus dem Verhältnis $H_S / H_P$ die Entfernung von der Oberfläche zu einem leitfähigen Medium **09** - hier das Meerwasser - berechnet werden. Alle magnetischen Wechselfelder induzieren in der Empfangsspule **08** eine Spannung $U_{Rxin}$, die vom Empfangsverstärker **11** verstärkt und anschließend als Spannung $U_{Rx}$ gemessen und ausgegeben wird. Um eine Aussage darüber treffen zu können, welche Spannung $U_{Rx}$ welchem Verhältnis $H_S / H_P$ entspricht, wird die Kalibrierspule **10** verwendet, die das bekannte Verhältnis von $H_{Cx} / H_P$ (= Kalibrierfaktor) erzeugt.

Die Darstellung der Messanordnung **01** in **Fig. 4** ist bezüglich einer optimalen Funktionsweise nicht vollständig. Es fehlen die Elemente, die nur bei der eigentlichen Messung erforderlich sind. Die **Fig. 5** zeigt den kompletten Aufbau der Messanordnung **01**. Hier sind zusätzlich noch eine Abnehmerspule **16** und eine Kompensationsspule **17** dargestellt. Da die Empfangsspule **08** nur das Sekundärfeld $H_S$ empfangen soll, aber das Primärfeld $H_P$ den Empfangsverstärker **11** in die Sättigung treiben würde, wird der Einfluss des Primärfeldes $H_P$ durch die Kompensationsspule **17** minimiert. Die Abnehmerspule **16** misst wiederum das Sendefeld $H_{Tx}$. Mit Hilfe der Abnehmerspule **16** können Schwankungen im Sendestrom $I_{Tx}$ und somit im ausgesendeten Magnetfeld $H_{Tx}$ kompensiert werden. Gezeigt sind noch die Spannungen $U_B$ an den Anschlüssen der Kompensationsspule **17,** $U_{RxL}$ an den Anschlüssen der Empfangsspule **08** und $U_{PU}$ an den Anschlüssen der Abnehmerspule **16**. Im kompletten Aufbau in **Fig. 5** ergibt sich die Spannung $U_{Rxin}$ am Eingang des Empfangsverstärkers **11** durch die Serienschaltung aus $U_B$ und $U_{RxL}$, wodurch der Einfluss des Primärfeldes $H_P$ am Ort der Empfangsspule **08** auf die Empfangsspannung $U_{Rxin}$ minimiert wird. Damit Schwankungen im Sendestrom $I_{Tx}$ nicht fälschlicherweise als Schwankungen im Sekundärfeld $H_S$ interpretiert werden, wird die Spannung $U_{PU}$ der Abnehmerspule **16** genutzt, um auftretende Schwankungen im Sendestrom $I_{Tx}$ zu kompensieren, da die Spannung $U_{PU}$ direkt proportional zu diesem ist (Sende- und Abnehmerspule sind ebenfalls induktiv gekoppelt).

**Formelzeichenliste**

| | |
|---|---|
| $A_{Cx}$ | effektive Fläche der Kalibrierspule **10** |
| $A_{Rx}$ | effektive Fläche der Empfangsspule **08** |
| $H_{Cx}$ | Kalibrierfeld, das während der Kalibrierung (zweite Stufe **S2**) als Sekundärfeld $H_S$ mit bekannter Stärke (Phase und Amplitude, im Verhältnis zum auftretenden, unbekannten Primärfeld $H_P$) fungiert |
| $H_P$ | Primärfeld, magnetisches Wechselfeld am Ort der Empfangsspule **08,** das über den Primärpfad **06** von der Sendespule **02** zur Empfangsspule **08** gelangt |
| $H_S$ | Sekundärfeld, magnetisches Wechselfeld am Ort der Empfangsspule **08,** das über den Sekundärpfad **07** von der Sendespule **02** zur Empfangsspule **08** gelangt |
| $H_{Tx}$ | Sendefeld, von der Sendespule **02** ausgesendetes magnetisches Wechselfeld |
| $H_{Cx}/H_P$ | Kalibrierfaktor |
| $I_{cal}$ | Strom durch die Kalibrierspule **10** während der Bestimmung des Kalibrierfaktors (erste Stufe **S1**) |

| $I_{Cx}$ | Strom durch die Kalibrierspule **10** während der Kalibrierung (zweite Stufe **S2**) |
|---|---|
| $I_{Tx}$ | Strom durch die Sendespule **02** während der Kalibrierung (zweite Stufe **S2**) und der eigentlichen Messungen |
| $j$ | imaginäre Einheit |
| $M_{RC}$ | Gegeninduktivität als Maß für die starke induktive Kopplung zwischen Kalibrierspule **10** und Empfangsspule **08** |
| $N_{Cx}$ | Windungsanzahl der Kalibrierspule **10** |
| $N_{Rx}$ | Windungsanzahl der Empfangsspule **08** |
| $U_B$ | Spannung an den Anschlüssen der Kompensationsspule **17,** dient zur Kompensation des Beitrags von Primärfeld $H_P$ auf die Empfangsspannung $U_{Rxin}$ |
| $U_{cal}$ | Spannung an den Anschlüssen des Kalibriersignalgenerators **12,** wird als Referenz zur Bestimmung der starken induktiven Kopplung zwischen Kalibrierspule **10** und Empfangsspule **08** genutzt |
| $U_{PU}$ | Spannung an den Anschlüssen der Abnehmerspule **16,** dient zur Kompensation von Schwankungen im Sendestrom $I_{Tx}$ |
| $U_{Rx}$ | Spannung am Ausgang des Empfangsverstärkers **11** (Messsignal) |
| $U_{Rxin}$ | Spannung am Eingang des Empfangsverstärkers **11** als Summe (Reihenschaltung) von $U_{Bx}$ und $U_{RxL}$ im vereinfachten Messaufbau **01** gemäß **Fig. 1** bis **4** |
| $U_{RxL}$ | Spannung an den Anschlüssen der Empfangsspule **08** im vollständigen Messaufbau **01** gemäß **Fig. 5** zur Unterscheidung zwischen der Spannung an der Empfangsspule **08** und der Spannung $U_{Rxin}$, die um den Einfluss des Primärfeldes $H_P$ kompensiert ist |
| $Z_{Cx}$ | komplexer Widerstand (Impedanz) der Serienschaltung von Kalibrierspule **10** und Kalibrierwiderstand **13** (veränderlicher Lastwiderstand) zur Veränderung des Kalibrierfeldes |
| $\omega$ | Kreisfrequenz |

## Bezugszeichenliste

| 01 | Messanordnung |
|---|---|
| 02 | Sendespule |
| 03 | Sendesignalgenerator |
| 04 | Sendeverstärker |
| 05 | Resonanzkondensator |
| 06 | Primärpfad |
| 07 | Sekundärpfad |
| 08 | Empfangsspule |
| 09 | leitfähiges Medium |
| 10 | Kalibrierspule |
| 11 | Empfangsverstärker |
| 12 | Kalibriersignalgenerator |
| 13 | veränderbarer Kalibrierwiderstand |
| 14 | erster Schalter für **S1** |
| 15 | weiterer Schalter für **S2** |
| 16 | Abnehmerspule |
| 17 | Kompensationsspule |
| 18 | Messgerät für $U_{cal}$ |
| 19 | Messgerät für $U_{Rxin}$ |
| 20 | Messgerät für $U_{Rx}$ |

| **S1** | erste Stufe, messtechnische Bestimmung des Kalibrierfaktors $H_{Cx}/H_P$ |
|---|---|
| **S2** | zweite Stufe, Durchführung der Kalibrierung |

## Patentansprüche

1. Indirektes Kalibrierverfahren für ein elektromagnetisches Induktionsverfahren zur Bestimmung von physikalischen Parametern eines elektrisch leitfähigen Mediums (09) aus dem Verhältnis ($H_S/H_P$) eines in einer Empfangsspule (08) empfangenen magnetischen Sekundärfelds (Hs) zu einem von einer mit einem Sendesignalgenerator (03) elektrisch verbundenen Sendespule (02) ausgesendeten magnetischen Primärfeld ($H_P$), wobei als Maß für das Verhältnis ($H_S/H_P$) eine Empfangsspannung ($U_{Rx}$) an einem Ausgang eines mit der Empfangsspule (08) elektrisch verbundenen Empfangsverstärkers (11) gemessen wird, die mittels einer Serienschaltung aus zumindest einer Kalibrierspule (10) und eines veränderbaren Kalibrierwiderstands (13) sowie eines durch diesen einstellbaren Kalibrierfaktors ($H_{Cx}/H_P$) kalibriert wird,

**wobei**

die Empfangsspule (08) dauerhaft mit der Kalibrierspule (10) unter Erzeugung einer Gegeninduktivität ($M_{RC}$) induktiv gekoppelt ist, wobei ein in der Kalibrierspule (10) erzeugter Kalibrierpuls ein Kalibrierfeld ($H_{Cx}$) und dieses einen magnetischen Fluss in der Empfangsspule (08) induziert und wobei die Flächen und Windungszahlen von Empfangsspule (08) und Kalibrierspule (10) bekannt sind, und wobei das Kalibrierverfahren zweistufig ausgebildet ist und umfasst eine

• erste Stufe, in der die Sendespule (02) inaktiv oder abgeschirmt und ein Kalibriersignalgenerator (12) an die Reihenschaltung von Kalibrierwiderstand (13) und Kalibrierspule (10) angeschlossenen ist und in der der Kalibrierpuls durch den Kalibriersignalgenerator (12) elektrisch erzeugt wird und unter Einstellung des Kalibrierwiderstands (13), über den Amplitude und Phase des Kalibrierfelds ($H_{Cx}$) einstellbar sind, eine Kalibrierspannung ($U_{cal}$) an der Serienschaltung von Kalibrierspule (10) und Kalibrierwiderstand (13) und die Empfangsspannung ($U_{Rxin}$) an der Empfangsspule (08) an einem Eingang des Empfangsverstärkers (11) gleichzeitig gemessen werden zum Bestimmen der erzeugten Gegeninduktivität ($M_{RC}$) zwischen der Kalibrierspule (10) und der Empfangsspule (08), aus der unter Einbeziehung der bekannten Flächen und Windungszahlen von Kalibrierspule (10) und Empfangsspule (08) der Kalibrierfaktor ($H_{Cx}/H_P$) messtechnisch ermittelt wird, und eine

• zweite Stufe, in der die Sendespule (02) über den Sendesignalgenerator (03) aktiv und die Kalibrierspule (10) über den in der ersten Stufe konstant eingestellten Kalibrierwiderstand (13) kurzgeschlossen ist und in der der Kalibrierpuls durch das von Sendesignalgenerator (03) und Sendespule (02) erzeugte Primärfeld ($H_P$) induktiv erzeugt wird und in der die Empfangsspannung am Ausgang des Empfangsverstärkers (11) gemessen wird, um diese als Maß für das Verhältnis ($H_S/H_P$) unter Anwendung des in der ersten Stufe messtechnisch ermittelten Kalibrierfaktors ($H_{Cx}/H_P$) zu kalibrieren.

2. Indirektes Kalibrierverfahren nach Anspruch 1,
   **dadurch gekennzeichnet, dass**
   zumindest in der zweiten Stufe das Sekundärfeld (Hs) abgeschirmt ist.

3. Indirektes Kalibrierverfahren nach Anspruch 1 oder 2,
   **dadurch gekennzeichnet, dass**
   die erste Stufe zeitlich unabhängig von der zweiten Stufe durchgeführt wird.

4. Messanordnung (01) zur Durchführung des indirekten Kalibrierverfahrens für ein elektromagnetischen Induktionsverfahren mit zumindest einer Sendespule (02) und einer Empfangsspule (08) sowie mit einer Serienschaltung zumindest aus einer Kalibrierspule (10) und einem Kalibrierwiderstand (13), nach einem der Ansprüche 1 bis 3,
   **dadurch gekennzeichnet, dass**
   die Empfangsspule (08) und die Kalibrierspule (10) unter Erzeugung einer dauerhaften induktiven Kopplung benachbart zueinander angeordnet sind und dass ein Kalibriersignalgenerator (12) vorgesehen ist, der mit der Serienschaltung elektrisch verbindbar ist.

5. Messanordnung (01) nach Anspruch 4,
   **dadurch gekennzeichnet, dass**
   ein erster Schalter (14) vorgesehen ist, über den die Kalibrierspule (10) über den Kalibrierwiderstand (13) mit dem Kalibriersignalgenerator (12) elektrisch verbindbar ist.

6. Messanordnung (01) nach Anspruch 4 oder 5,
   **dadurch gekennzeichnet, dass**
   ein weiterer Schalter (15) vorgesehen ist, über den die Kalibrierspule (10) nur mit dem Kalibrierwiderstand (13) elektrisch verbindbar ist.

7. Messanordnung (01) nach einem der vorangehenden Ansprüche 4 bis 6, **dadurch gekennzeichnet, dass**

die Empfangsspule (08) und die Kalibrierspule (10) auf einem gemeinsamen Kern angeordnet sind und ein Flächenverhältnis von 1 aufweisen.

8.  Messanordnung (01) nach einem der vorangehenden Ansprüche 4 bis 7, **dadurch gekennzeichnet, dass**
    die Empfangsspule (08) und die Kalibrierspule (10) ein Wicklungsverhältnis von 1 aufweisen.

**Claims**

1.  Indirect calibration method for an electromagnetic induction method for the determination of physical parameters of an electrically conductive medium (09) from the ratio ($H_S/H_P$) of a secondary magnetic field (Hs), received in a receiving coil (08), to a primary magnetic field ($H_P$) emitted by a transmitting coil (02) electrically connected to a transmission signal generator (03), wherein as a measure for the ratio ($H_S/H_P$) a received voltage (URx) is measured at an output of a receiving amplifier (11) electrically connected to the receiving coil (08), said received voltage being calibrated using a series circuit of at least one calibration coil (10) and a variable calibration resistor (13) and using a calibration factor ($H_{Cx}/H_P$) which is adjustable thereby,
    **wherein**

    the receiving coil (08) is permanently inductively coupled to the calibration coil (10), generating a mutual inductance ($M_{RC}$), wherein a calibration pulse generated in the calibration coil (10) induces a calibration field ($H_{Cx}$) and this induces a magnetic flux in the receiving coil (08) and wherein the areas and numbers of turns of the receiving coil (08) and calibration coil (10) are known,
    and wherein the calibration method has two stages and comprises a

    • first stage, in which the transmission coil (02) is inactive or shielded and a calibration signal generator (12) is connected to the series circuit of calibration resistor (13) and calibration coil (10), and in which the calibration pulse is generated electrically by the calibration signal generator (12) and by adjusting the calibration resistor (13), via which the amplitude and phase of the calibration field ($H_{Cx}$) can be adjusted, a calibration voltage ($U_{cal}$) at the series circuit of calibration coil (10) and calibration resistor (13) and the received voltage ($U_{Rxin}$) at the receiving coil (08) at an input of the receiving amplifier (11) are simultaneously measured to determine the mutual inductance ($M_{RC}$) generated between the calibration coil (10) and the receiving coil (08), from which the calibration factor ($H_{Cx}/H_P$) is determined, taking into account the known areas and numbers of turns of the calibration coil (10) and receiving coil (08),
    and a
    • second stage, in which the transmitting coil (02) is active via the transmit signal generator (03) and the calibration coil (10) is short-circuited via the calibration resistor (13) that was adjusted to a constant value in the first stage, and in which the calibration pulse is inductively generated by the primary field ($H_P$) generated by transmission signal generator (03) and transmitting coil (02), and in which the received voltage is measured at the output of the receiving amplifier (11) in order to calibrate said voltage as a measure of the ratio ($H_S/H_P$) by using the calibration factor ($H_{Cx}/H_P$) metrologically determined in the first stage.

2.  Indirect calibration method according to Claim 1, **characterized in that**
    at least in the second stage, the secondary field (Hs) is shielded.

3.  Indirect calibration method according to Claim 1 or 2, **characterized in that**
    the first stage is carried out independently of the second stage.

4.  Measuring assembly (01) for carrying out the indirect calibration method for an electromagnetic induction method having at least one transmitting coil (02) and a receiving coil (08) and having a series circuit comprising at least one calibration coil (10) and a calibration resistor (13), according to any one of Claims 1 to 3,
    **characterized in that**
    the receiving coil (08) and the calibration coil (10) are arranged adjacent to each other, generating a permanent inductive coupling, and that a calibration signal generator (12) is provided, which can be electrically connected to the series circuit.

5.  Measuring assembly (01) according to Claim 4, **characterized in that**
    a first switch (14) is provided, by means of which the calibration coil (10) can be electrically connected to the calibration signal generator (12) via the calibration resistor (13).

6. Measuring assembly (01) according to Claim 4 or 5, **characterized in that**
a further switch (15) is provided, by means of which the calibration coil (10) can be electrically connected only to the calibration resistor (13).

7. Measuring assembly (01) according to any one of the preceding Claims 4 to 6,
**characterized in that**
the receiving coil (08) and the calibration coil (10) are arranged on a common core and have an area ratio of 1.

8. Measuring assembly (01) according to any one of the preceding Claims 4 to 7,
**characterized in that**
the receiving coil (08) and the calibration coil (10) have a winding ratio of 1.


**Revendications**

1. Procédé d'étalonnage indirect pour un procédé d'induction électromagnétique pour la détermination des paramètres physiques d'un milieu électriquement conducteur (09) à partir du rapport ($H_S/H_P$) entre un champ magnétique secondaire ($H_S$) reçu par une bobine de réception (08) et un champ magnétique primaire (HP) émis par une bobine d'émission (02) connectée électriquement à un générateur de signaux d'émission (03), dans lequel une tension de réception ($U_{Rx}$) à la sortie d'un amplificateur de réception (11) connecté électriquement à la bobine de réception (08) est mesurée comme mesure pour le rapport ($H_S/H_P$), qui est étalonné au moyen d'un circuit série comprenant au moins une bobine d'étalonnage (10) et une résistance d'étalonnage variable (13), ainsi qu'un facteur d'étalonnage ($H_{Cx}/H_P$) ajustable par cette résistance,
**dans lequel**
la bobine de réception (08) est couplée inductivement en permanence à la bobine d'étalonnage (10), en générant une inductance mutuelle ($M_{RC}$), dans lequel une impulsion d'étalonnage générée dans la bobine d'étalonnage (10) induit un champ d'étalonnage ($H_{Cx}$) qui génère un flux magnétique dans la bobine de réception (08) et dans lequel la surface et le nombre de spires de la bobine de réception (08) et de la bobine d'étalonnage (10) sont connus et dans lequel la procédé d'étalonnage est conçue en deux étapes et comprend :

   • une première étape dans laquelle la bobine d'émission (02) est inactive ou blindée et un générateur de signal d'étalonnage (12) est connecté à la connexion série de la résistance d'étalonnage (13) et de la bobine d'étalonnage (10) et dans lequel l'impulsion d'étalonnage est générée électriquement par le générateur de signal d'étalonnage (12), et en ajustant la résistance d'étalonnage (13), par laquelle l'amplitude et la phase du champ d'étalonnage ($H_{Cx}$) sont ajustables, une tension d'étalonnage ($U_{cal}$) appliquée au circuit série de la bobine d'étalonnage (10) et la résistance d'étalonnage (13) et la tension de réception ($U_{Rxin}$) à la bobine de réception (08) à une entrée de l'amplificateur de réception (11) sont mesurées simultanément pour déterminer l'inductance mutuelle générée ($M_{RC}$) entre la bobine d'étalonnage (10) et la bobine de réception (08), à partir de laquelle, en tenant compte de la surface et du nombre de spires connus de La bobine d'étalonnage (10) et la bobine de réception (08), le facteur d'étalonnage ($H_{Cs}/H_P$) est déterminé métrologiquement,
   et une
   • deuxième étape, dans laquelle la bobine d'émission (02) est activée par le générateur de signal d'émission (03) et la bobine d'étalonnage (10) est court-circuitée par la résistance d'étalonnage (13) fixée à une valeur constante dans la première étape et dans laquelle l'impulsion d'étalonnage est générée inductivement par le champ primaire ($H_P$) généré par le générateur de signal d'émission (03) et la bobine d'émission (02) et dans lequel la tension de réception à la sortie de l'amplificateur de réception (11) est mesurée afin de l'étalonner comme mesure du rapport ($H_S/H_P$) en appliquant le facteur d'étalonnage ($H_{Cx}/H_P$) déterminé métrologiquement dans la première étape.

2. Procédé d'étalonnage indirect selon la revendication 1, **caractérisé en ce que**
au moins dans la deuxième étape, le champ secondaire ($H_S$) est blindé.

3. Procédé d'étalonnage indirect selon la revendication 1 ou 2,
**caractérisé en ce que**
la première étape est exécutée temporellement indépendamment de la deuxième étape.

4. Dispositif de mesure (01) pour la mise en œuvre du procédé d'étalonnage indirect pour un procédé d'induction électromagnétique, comportant au moins une bobine d'émission (02) et une bobine de réception (08), ainsi qu'un circuit série constitué d'au moins une bobine d'étalonnage (10) et une résistance d'étalonnage (13), selon l'une des revendications 1 à 3, **caractérisé en ce que**
la bobine de réception (08) et la bobine d'étalonnage (10) sont disposées côte à côte en générant un couplage inductif permanent et qu'un générateur de signal d'étalonnage (12) est prévu et peut être connecté électriquement au circuit série.

5. Dispositif de mesure (01) selon la revendication 4, **caractérisé en ce que**
un premier commutateur (14) est prévu, permettant de connecter électriquement la bobine d'étalonnage (10) au générateur de signal d'étalonnage (12) via la résistance d'étalonnage (13).

6. Dispositif de mesure (01) selon la revendication 4 ou 5,
**caractérisé en ce que**
un commutateur supplémentaire (15) est prévu, permettant de connecter électriquement la bobine d'étalonnage (10) uniquement à la résistance d'étalonnage (13).

7. Dispositif de mesure (01) selon une des revendications 4 à 6 précédentes,
**caractérisé en ce que**
la bobine de réception (08) et la bobine d'étalonnage (10) sont disposées sur un noyau commun et présentent un rapport de surface de 1.

8. Dispositif de mesure (01) selon une des revendications 4 à 7 précédentes,
**caractérisé en ce que**
la bobine de réception (08) et la bobine d'étalonnage (10) présentent un rapport d'enroulement de 1.

Fig.1 S1

Fig.2  S2

Fig.3 S1+S2

Fig.4

Fig.5

EP 4 409 311 B1

18

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4000018 C2
- WO 20121146930 A2
- EP 2790030 A1
- DE 102009026403 A1
- EP 2657762 A2
- DE 102018220532 A1
- DE 202005020193 U1
- US 20150268369 A1
- WO 2012146930 A1

**In der Beschreibung aufgeführte Nicht-Patentliteratur**

- **WANG, HAOWEN**. A time-domain feedback calibration method for air-coil magnetic sensor. *Measurement*, vol. 135 (2029), ISSN 0263-2241, 61-70
- **HAAS, CHRISTIAN**. Airborne electromagnetic measurements of sea ice thickness: methods and application. Luxembourg: Arctic sea ice thickness: past, present and future.. *Office for Official Publications of the European Communities*, 2006, ISBN 92-79-02803-0, 136-148